# EUROPÄISCHE PATENTSCHRIFT

(11) **EP 1 921 900 B1**
(45) Veröffentlichungstag und Bekanntmachung des Hinweises auf die Patenterteilung: **01.08.2012**
(21) Anmeldenummer: 07120129.7
(22) Anmeldetag: 07.11.2007
(51) Int. Cl.: H05B 37/02

(54) **Beleuchtungsvorrichtung mit einer Lichtquelle und einer Tastvorrichtung**
Illumination device with a light source and a touch actuator
Dispositif d'éclairage doté d'une source lumineuse et d'un interrupteur à effleurement

(30) Priorität: 09.11.2006 DE 102006052949
(43) Veröffentlichungstag der Anmeldung: 14.05.2008
(73) Patentinhaber: OSRAM AG, 81543 München (DE)
(72) Erfinder: Siegmund, Thomas, 83624, Otterfing (DE)

(56) Entgegenhaltungen:
- EP-A1- 0 533 336
- US-A- 5 825 603
- US-A1- 2004 109 270

## Beschreibung

### Technisches Gebiet

Die vorliegende Erfindung betrifft eine Beleuchtungsvorrichtung mit einer Lichtquelle und einer Tastvorrichtung, die einen Taster, einen Anschluss für eine Versorgungsspannung und ein D-Flip-Flop umfasst, wobei das D-Flip-Flop einen Set-Eingang, einen Reset-Eingang, einen Clock-Eingang, einen Daten-Eingang, einen Q-Ausgang und einen Qbar-Ausgang aufweist, wobei die Lichtquelle am Q-Ausgang oder am Qbar-Ausgang angeschlossen ist, wobei der Taster einen ersten und einen zweiten Anschluss aufweist, wobei der erste Anschluss mit dem Anschluss für die Versorgungsspannung verbunden ist und der zweite Anschluss mit der Versorgungsspannung verbindbar ist.

### Stand der Technik

In modernen Leuchten kommen zunehmend flache Taster und Folientaster zum Einsatz, mit denen beispielsweise die Lichtquelle geschaltet oder gedimmt werden soll. Zur Vermeidung von unbeabsichtigten Fehlfunktionen des Tasters sollte die nachgeschaltete Elektronik unempfindlich gegenüber direkt eingekoppelten ESD (electrostatic discharge)-Störungen auf den Taster bzw. unabhängig von Einkopplungen auf die unabgeschirmten Tasterzuleitungen sein. Ein typisches Beispiel für ESD-Störungen sind die Spannungen, die durch Reibung von Schuhen auf einem Kunststoffboden entstehen und bis 10 kV betragen können. Sie werden im Nachfolgenden als AC-Störsignal bezeichnet. Ein Impuls von ESD-Störungen ist damit vergleichbar mit einem Tasterimpuls und kann bei einem flankengetriggerten D-Flip-Flop beispielsweise zu einer schnellen Abfolge von Ein- und Ausschalten der Lichtquelle führen. Dies ist natürlich unerwünscht.

Aus dem Stand der Technik sind generell drei unterschiedliche Gruppen von ESD-Schutzmaßnahmen bekannt:
Die US 6,977,420 B2, die US 6,472,286 B1, die US 2005/0269641 A1, die WO 2006/033993 A1 sowie die US 2003/0197246 A1 betreffen integrierte Schutzschaltungen mit Schutzdioden. Die US 6,560,081 B1 betrifft diskrete Schutzschaltungen mit externen Bipolartransistoren und die US 6,323 445 B1 sowie die WO 00/77805 A1 betreffen ESD-Abschirmungen.

Die aus dem Stand der Technik bekannten Maßnahmen gegen ESD-Störungen weisen leider eine komplexe Schaltungstopologie auf, bedürfen daher viel Platz und lassen sich nicht kostengünstig realisieren.

### Darstellung der Erfindung

Die Aufgabe der vorliegenden Erfindung besteht deshalb darin, eine gattungsgemäße Beleuchtungsvorrichtung derart weiterzubilden, dass es die unerwünschten Effekte von ESD-Störungen verhindert und zwar bei einer möglichst einfachen Schaltungstopologie, die möglichst wenig Platz braucht und sich kostengünstig realisieren lässt.

Diese Aufgabe wird gelöst durch eine Beleuchtungsvorrichtung mit den Merkmalen von Patentanspruch 1 mit den Merkmalen von Patentanspruch 8.

Der vorliegenden Erfindung liegt die Erkenntnis zugrunde, dass die negativen Auswirkungen von ESD-Störungen wirksam verhindert werden können, wenn ein Entstörnetzwerk vorgesehen wird, das mit einem Bezugspotential gekoppelt ist, und zwar derart, dass die ESD-Störungen über dieses Entstörnetzwerk mit einem Bezugspotential kurzgeschlossen werden, während das eigentliche Schaltsignal durch das Entstörnetzwerk weitestgehend unbeeinflusst bleibt.

Wie sich im Nachfolgenden zeigen wird, lässt sich ein derartiges Entstörnetzwerk bereits mit zwei Bauteilen realisieren, so dass eine sehr einfache Schaltungstopologie gegeben ist, die entsprechend wenig Platz braucht und bei sehr geringen Kosten realisierbar ist.

Im Hinblick darauf, dass das Entstörnetzwerk für die ESD-Störungen einen niederohmigen Widerstand darstellen soll, während es für das eigentliche Schaltsignal einen hochohmigen Widerstand darstellen soll, ergibt sich auch eine sehr einfache Dimensionierungsvorschrift.

Bei einer bevorzugten Ausführungsform ist vorgesehen, dass der Anschluss für ein Bezugspotential den Anschluss für die Versorgungsspannung darstellt. Bevorzugt weist das Entstörnetzwerk mindestens einen ohmschen Widerstand und mindestens einen Kondensator auf, die in Serie zueinander geschaltet sind. Bei Verwendung genau eines ohmschen Widerstands und eines Kondensators ergibt sich die Minimalausstattung einer Realisierung des Entstörnetzwerks, die in besonders geringen Kosten und einem besonders geringem Platzbedarf resultiert. Selbstverständlich kann die Realisierung eines niederohmigen Widerstands für das ESD-Störsignal bzw. eines hochohmigen Widerstands für das eigentliche Schaltsignal auch durch die Hinzunahme weiterer LRC-Bauelemente realisiert werden.

Bei einer bevorzugten Ausbildung des Entstörnetzwerks ist der erste Anschluss und der zweite Anschluss des Entstörnetzwerks mit dem vom Kondensator abgekehrten Anschluss des ohmschen Widerstands gekoppelt, und der dritte Anschluss des Entstörnetzwerks mit dem vom ohmschen Widerstand abgekehrten Anschluss des Kondensators gekoppelt. Alternativ hierzu kann der erste Anschluss des Entstörnetzwerks mit dem vom Kondensator abgekehrten Anschluss des ohmschen Widerstands gekoppelt sein, der zweite Anschluss des Entstörnetzwerks mit dem Verbindungspunkt zwischen dem ohmschen Widerstand und dem Kondensator und der dritte Anschluss des Entstörnetzwerks mit dem vom ohmschen Widerstand abgekehrten Anschluss des Kondensators.

Eine erfindungsgemäße Beleuchtungsvorrichtung umfasst weiterhin bevorzugt ein Zeitglied mit einer Zeitkonstante, wobei das Zeitglied ebenfalls einen ersten, einen zweiten und einen dritten Anschluss aufweist, wobei der erste Anschluss an den zweiten Anschluss des Entstörnetzwerks gekoppelt ist, wobei der zweite Anschluss des Zeitglieds mit einem Bezugspotential gekoppelt ist, und wobei der dritte Anschluss des Zeitglieds mit dem Clock-Eingang gekoppelt ist. Ein derartiges Zeitglied wurde bereits in der noch nicht veröffentlichten europäischen Anmeldung, Aktenzeichen 6 010 545.9, vorgestellt und wirkt letztendlich als Impulsformer. Dabei wird der aufgrund des Schließens des Tasters erzeugte Impuls, insbesondere dessen ansteigende Flanke, unabhängig vom Loslassen des Tasters zu einem einzelnen Impuls am Clock-Eingang des D-Flip-Flops umgewandelt. Es umfasst bevorzugt die Parallelschaltung eines ersten ohmschen Widerstands und eines Kondensators, wobei diese Parallelschaltung in Serie geschaltet ist zu einem zweiten ohmschen Widerstand. Der Verbindungspunkt zwischen der Parallelschaltung des ersten ohmschen Widerstands und des Kondensators einerseits und des zweiten ohmschen Widerstands andererseits ist mit dem Clock-Eingang des D-Flip-Flops verbunden. Dabei ist der dem Kondensator parallelgeschaltete erste ohmsche Widerstand hochohmig dimensioniert und dient dem Entladen des Kondensators, um diesen erneut in Betriebsbereitschaft zu bringen. Der zweite ohmsche Widerstand ist deutlich kleiner dimensioniert und lässt den Ladestrom für den Kondensator zu, wobei der Ladestrom an diesem zweiten ohmschen Widerstand den Spannungssprung für den Clock-Eingang des D-Flip-Flop erzeugt. Ein typischer Wert für den ersten ohmschen Widerstand ist etwa 100 kΩ, für den Kondensator 10 nF und für den zweiten ohmschen Widerstand 10 kΩ.

Bei einer bevorzugten Ausführungsform ist die Verbindung vom ersten Anschluss des Entstörnetzwerks zum zweiten Anschluss des Zeitglieds durch einen ersten vorgebbaren Widerstand definiert, wobei die Verbindung vom ersten zum dritten Anschluss des Entstörnetzwerks durch einen zweiten vorgebbaren Widerstand definiert ist, wobei für ein DC-Signal der erste vorgebbare Widerstand um mindestens einen Faktor 10 kleiner ist als der zweite vorgebbare Widerstand, und wobei für das AC-Störsignal der erste vorgebbare Widerstand um mindestens einen Faktor 10 größer ist als der zweite vorgebbare Widerstand. Bei besonders bevorzugten Ausführungsformen beträgt der jeweilige Faktor mindestens 100.

Weitere bevorzugte Ausführungsformen ergeben sich aus den Unteransprüchen.

### Kurze Beschreibung der Zeichnung(en)

Im Nachfolgenden werden nunmehr zwei Ausführungsbeispiele einer erfindungsgemäßen Beleuchtungsvorrichtung mit Bezug auf die beigefügten Zeichnungen näher beschrieben. Es zeigen:
- Fig. 1: in schematischer Darstellung einen Schaltplan für eine erfindungsgemäße Beleuchtungsvorrichtung nach einer ersten Ausführungsform (A) und einer zweiten Ausführungsform (B);
- Fig. 2: den zeitlichen Verlauf des Störsignals am Clock-Eingang des D-Flip-Flops (oben) sowie den Spannungsverlauf am Anschluss A2 des Tasters (unten) für eine Ausführungsform nach dem Stand der Technik;
- Fig. 3: den zeitlichen Verlauf des Störsignals am Clock-Eingang des D-Flip-Flops (oben) sowie den Spannungsverlauf am Anschluss A2 des Tasters (unten) für ein Ausführungsbeispiel einer erfindungsgemä-ßen Beleuchtungsvorrichtung; und
- Fig. 4: den zeitlichen Verlauf des Störsignals am Clock-Eingang des D-Flip-Flops (oben) sowie den Spannungsverlauf am Anschluss A2 des Tasters (unten) für das Ausführungsbeispiel einer erfindungsgemäßen Beleuchtungsvorrichtung von Fig. 3 in vergrößerter zeitlicher Auflösung.

### Bevorzugte Ausführung der Erfindung

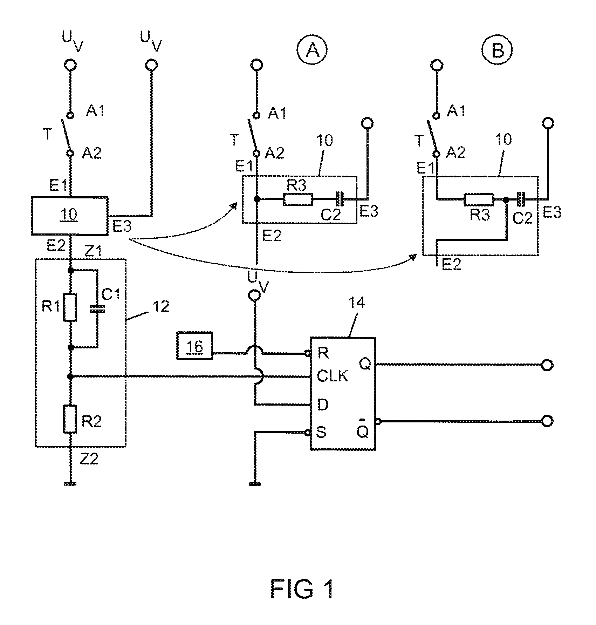

Die Fig. 1 zeigt in schematischer Darstellung zwei Ausführungsbeispiele einer erfindungsgemäßen Beleuchtungsvorrichtung, wobei im ersten Ausführungsbeispiel das Entstörnetzwerk 10 gemäß Darstellung A realisiert ist und das zweite Ausführungsbeispiel gemäß der Darstellung B. Im Stand der Technik wären in dem Entstörnetzwerk, das drei Anschlüsse E1, E2, E3 aufweist, die Anschlüsse E1 und E2 durch einen Kurzschluss verbunden, die Anschlüsse E3 und E1 einerseits bzw. E3 und E2 andererseits durch jeweils einen Leerlauf. Die Schaltungsanordnung umfasst einen Taster T, dessen Anschluss A1 mit einer Versorgungsspannung Uᵥ verbunden ist und dessen Anschluss A2 mit dem Eingang E1 des Entstörnetzwerks verbunden ist und erst beim Schließen des Tasters T mit der Versorgungsspannung Uᵥ verbunden wird. Die erfindungsgemäße Beleuchtungsvorrichtung umfasst weiterhin ein Zeitglied 12, dessen erster Anschluss Z1 mit dem Anschluss E2 des Entstörglieds 10 verbunden ist, dessen Anschluss Z2 mit dem Bezugspotential verbunden ist, vorliegend Masse, und dessen Anschluss Z3 mit dem Clock-Eingang des D-Flip-Flops 14 verbunden ist. Das Zeitglied 12 umfasst die Parallelschaltung eines ohmschen Widerstands R1 und eines Kondensators C1, die zu einem ohmschen Widerstand R2 in Serie geschaltet sind. Der Verbindungspunkt zwischen der Parallelschaltung aus dem ohmschen Widerstand R1 und dem Kondensator C1 einerseits und dem ohmschen Widerstand R2 andererseits ist mit dem Ausgang Z3 des Zeitglieds 12 verbunden. Das D-Flip-Flop 14 kann beispielsweise vom Typ CD4013BM sein und weist den bereits erwähnten Clock-Eingang CLK auf, darüber hinaus einen Reset-Eingang R, einen Set-Eingang S, einen Dateneingang D, einen Ausgang Q und einen Ausgang Qbar. Dabei kann die Lichtquelle am Q-Ausgang oder am Qbar-Ausgang angeschlossen sein. Wie deutlich zu sehen, ist der Set-Eingang S mit dem Bezugspotential, vorliegend Masse, der Reset-Eingang R mit einer Resetvorrichtung 16 verbunden. Der D-Eingang kann beispielsweise, wie gezeigt, mit der Versorgungsspannung Uᵥ gekoppelt sein.

Im Stand der Technik wird beim Drücken des Tasters T der Kondensator C1 über den ohmschen Widerstand R2 mit der Zeitkonstante τ = C1 • R2 sehr schnell aufgeladen. Die Zeitkonstante τ beträgt im Ausführungsbeispiel 0,1 ms. Durch den wegen des Tasterprellens pulsförmigen Ladestrom über R2 fällt an diesem Widerstand eine pulsförmige Spannung ab, die am Clock-Eingang CLK des D-Flip-Flops 14 anliegt. Die erste ansteigende Flanke dieses Signals triggert das D-Flip-Flop 14. Dadurch ändern sich die Pegel der Ausgänge Q und Qbar.

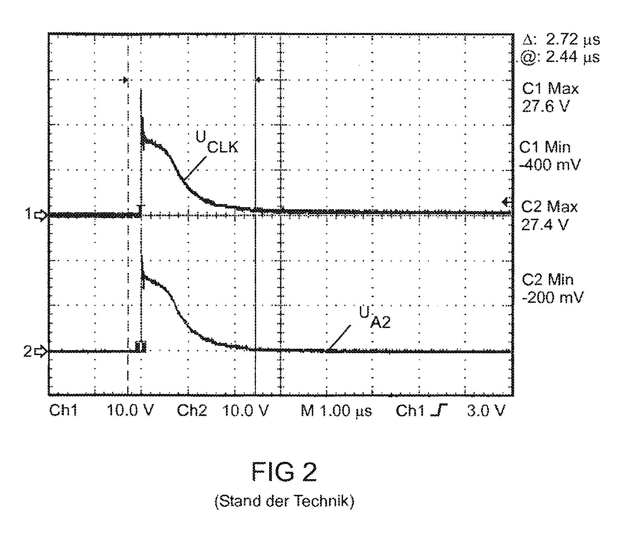

Durch ESD-Einkopplungen, also AC-Störsignale, auf den Anschluss A2 des Tasters T und auf die Tasterzuleitungen entstehen am Anschluss A2 Transienten mit hoher Amplitude, siehe hierzu den zeitlichen Verlauf der Spannung U_{A2} am Anschluss A2 in Fig. 2. Das Signal gelangt über den Kondensator C1 an den Clock-Eingang CLK des D-Flip-Flops 14, siehe den entsprechenden zeitlichen Verlauf der Spannung U_{CLK} in Fig. 2, und triggert dieses in unerwünschter Weise. Geht man davon aus, dass eine Spannung von 5 V am Clock-Eingang noch zum Schalten des D-Flip-Flops 14 führt, so liegt beim Stand der Technik über einen Zeitraum von ca. 1 ms eine einen Schaltvorgang des D-Flip-Flops 14 auslösende Spannung am Clock-Eingang an. Fortwährendes Ein- und Ausschalten der beispielsweise am Q-Ausgang des D-Flip-Flops 14 angeschlossenen Lichtquelle ist die Folge.

Gemäß der in Fig. 1 vorgestellten Variante A umfasst das Entstörnetzwerk einen ohmschen Widerstand R3 und einen Kondensator C2, wobei die Anschlüsse E1 und E2 des Entstörnetzwerks 10 durch einen Kurzschluss verbunden sind und der Anschluss E3 über die Serienschaltung aus C2 und R3 mit den Eingängen E1 und E2 verbunden ist. Gemäß der in Fig. 1 dargestellten Variante B ist der erste Anschluss E1 des Entstörnetzwerks 10 mit dem vom Kondensator C2 abgekehrten Anschluss des ohmschen Widerstands R3 verbunden, ein zweiter Anschluss E2 des Entstörnetzwerks mit dem Verbindungspunkt zwischen dem ohmschen Widerstand R3 und dem Kondensator C2 und ein dritter Anschluss E3 des Entstörnetzwerks mit dem vom ohmschen Widerstand R3 abgekehrten Anschluss des Kondensators C2.

Bei einer bevorzugten Realisierung beträgt der Wert des ohmschen Widerstands R3 10 Ω, die Kapazität des Kondensators C2 100 nF.

Schlicht ausgedrückt bilden der ohmsche Widerstand R3 und der Kondensator C2 einen Bypass, mit dem die am Anschluss A2 eingekoppelten ESD-Störungen wirksam gegen die Versorgungsspannung Uᵥ abgeleitet werden. Grundsätzliche Voraussetzung ist, dass die am Kondensator C2 bewirkte Impedanz für das gewünschte Schaltsignal sehr viel größer ist als die vom Kondensator C1 bewirkte Impedanz. Für das AC-Störsignal sollen die Verhältnisse genau umgekehrt sein. Der ohmsche Widerstand R3 dient im übrigen zur Strombegrenzung des Tasterstroms beim Einschalten und gleichzeitigem Entladen des Kondensators C2.

Für ESD-Störsignale ist damit der Anschluss A2 des Tasters T über den ohmschen Widerstand R3 und den Kondensator C2 niederohmig an die Versorgungsspannung Uᵥ angekoppelt. Hohe Spannungen können sich nicht mehr am Anschluss A2 aufbauen. Umgekehrt werden infolge des seriell angeordneten Kondensators C2 die erwünschten Taster-DC-Signale von dem Entstörnetzwerk 10 einer erfindungsgemäßen Beleuchtungsvorrichtung nicht berührt. Die Verbindung des Entstörnetzwerks 10 stellt für die letztgenannten Signale zwischen dem Anschluss E1 und dem Anschluss E3 einen hochohmigen Widerstand dar und zwischen dem Anschluss E1 und dem Anschluss E2 einen niederohmigen Widerstand, im Falle der Variante A sogar einen Kurzschluß.

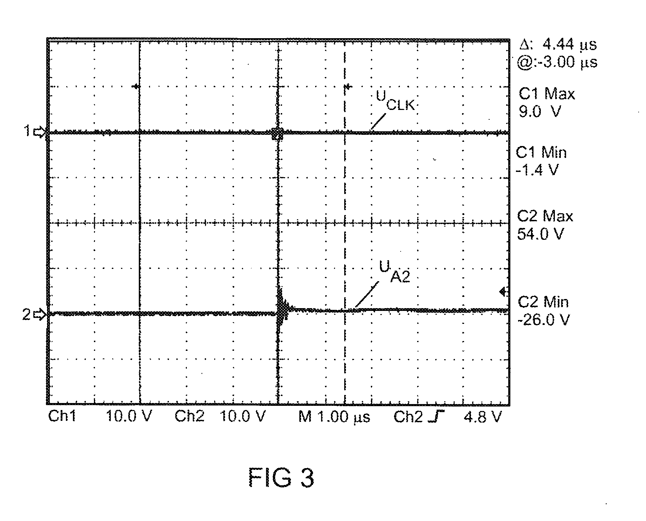

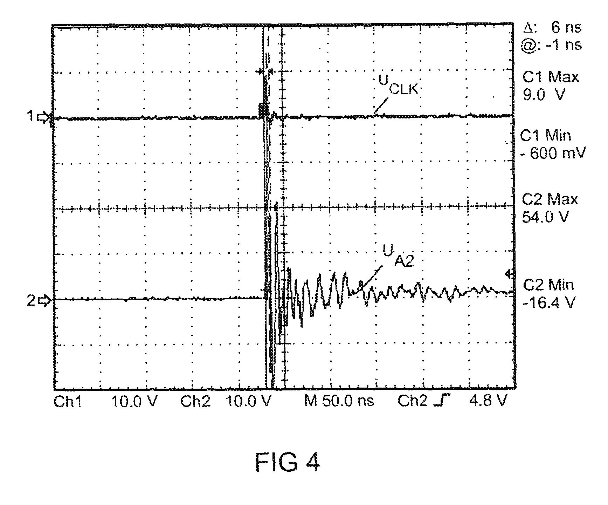

Das Ergebnis für die Variante A gemäß Fig. 1 ist in den Figuren 3 und 4 dargestellt: Während die Darstellung von Fig. 3 die gleiche zeitliche Auflösung aufweist wie die Darstellung von Fig. 2 (1 Kästchen entspricht 1 ms), zeigt Fig. 4 eine in zeitlicher Hinsicht vergrößerte Darstellung von Fig. 3 (1 Kästchen entspricht 50 ns). Fig. 3 zeigt, dass sich am Anschluss A2 des Tasters T nurmehr für einen kurzen zeitlichen Moment eine Spannung U_{A2} ergibt. Entsprechendes gilt für die Spannung U_{CLK} am Clock-Eingang CLK. Mit Bezug auf Fig. 4 beträgt der Zeitraum, in dem die Spannung U_{CLK} am Clock-Eingang CLK größer als die Schaltschwelle von 5 V ist, nur noch 6 ns. Bei einer typischen Setup-Zeit des D-Flip-Flops 14 von 20 ns ergibt sich als Ergebnis, dass es trotz der über den Taster T eingeführten ESD-Störungen - wie gewünscht - zu keinem unerwünschten Schaltvorgang des D-Flip-Flops 14 kommt.

## Patentansprüche

1. Beleuchtungsvorrichtung mit einer Lichtquelle und einer Tastvorrichtung, die einen Taster (T), einen Anschluss für eine Versorgungsspannung (Uᵥ) und ein D-Flip-Flop (14) umfasst, wobei das D-Flip-Flop (14) einen Set-Eingang (S), einen Reset-Eingang (R), einen Clock-Eingang (CLK), einen Daten-Eingang (D), einen Q-Ausgang (Q) und einen Qbar-Ausgang aufweist, wobei die Lichtquelle am Q-Ausgang (Q) oder am Qbar-Ausgang angeschlossen ist,
wobei der Taster (T) einen ersten (A1) und einen zweiten Anschluss (A2) aufweist, wobei der erste Anschluss (A1) mit dem Anschluss für die Versorgungsspannung (Uᵥ) verbunden ist und der zweite Anschluss (A2) mit der Versorgungsspannung (Uᵥ) verbindbar ist,
**dadurch gekennzeichnet,**
**dass** sie weiterhin umfasst:
ein Entstörnetzwerk (10), das einen ersten (E1), einen zweiten (E2) und einen dritten Anschluss (E3) aufweist, wobei der erste Anschluss (E1) des Entstörnetzwerks (10) mit dem zweiten Anschluss (A2) des Tasters (T), der zweite Anschluss (E2) des Entstörnetzwerks (10) mit dem Clock-Eingang (CLK) und der dritte Anschluss (E3) des Entstörnetzwerks (10) mit einem Anschluss für ein Bezugspotential (Uᵥ) gekoppelt ist,
wobei das Entstörnetzwerk (10) zwischen seinem ersten (E1) und seinem dritten Anschluss (E3) eine Verbindung aufweist, die für ein DC-Signal einen hochohmigen Widerstand und für ein AC-Störsignal einen niederohmigen Widerstand darstellt.

2. Beleuchtungsvorrichtung nach Anspruch 1,
**dadurch gekennzeichnet,**
**dass** der Anschluss für ein Bezugspotential den Anschluss für die Versorgungsspannung (Uv) darstellt.

3. Beleuchtungsvorrichtung nach einem der Ansprüche 1 oder 2,
**dadurch gekennzeichnet,**
**dass** das Entstörnetzwerk (10) mindestens einen ohmschen Widerstand (R3) und mindestens einen Kondensator (C2) umfasst, die in Serie zueinander geschaltet sind.

4. Beleuchtungsvorrichtung nach Anspruch 3,
**dadurch gekennzeichnet,**
**dass** der erste Anschluss (E1) und der zweite Anschluss (E2) des Entstörnetzwerks (10) mit dem vom Kondensator (C2) abgekehrten Anschluss des ohmschen Widerstands (R3) gekoppelt sind, und dass der dritte Anschluss (E3) des Entstörnetzwerks (10) mit dem vom ohmschen Widerstand (R3) abgekehrten Anschluss des Kondensators (C2) gekoppelt ist.

5. Beleuchtungsvorrichtung nach Anspruch 3,
**dadurch gekennzeichnet,**
**dass** der erste Anschluss (E1) des Entstörnetzwerks (10) mit dem vom Kondensator (C2) abgekehrten Anschluss des ohmschen Widerstands (R3) gekoppelt ist, dass der zweite Anschluss (E2) des Entstörnetzwerks (10) mit dem Verbindungspunkt zwischen dem ohmschen Widerstand (R3) und dem Kondensator (C2) gekoppelt ist, und dass der dritte Anschluss (E3) des Entstörnetzwerks (10) mit dem vom ohmschen Widerstand (R3) abgekehrten Anschluss des Kondensators (C2) gekoppelt ist.

6. Beleuchtungsvorrichtung nach einem der vorhergehenden Ansprüche,
**dadurch gekennzeichnet,**
**dass** sie weiterhin umfasst:
ein Zeitglied (12) mit einer Zeitkonstante, wobei das Zeitglied (12) ebenfalls einen ersten (Z1), einen zweiten (Z2) und einen dritten Anschluss (Z3) aufweist, wobei der erste Anschluss (Z1) an den zweiten Anschluss (E2) des Entstörnetzwerks (10) gekoppelt ist, wobei der zweite Anschluss (Z2) des Zeitglieds (12) mit einem Bezugspotential gekoppelt ist, und wobei der dritte Anschluss (Z3) des Zeitglieds (12) mit dem Clock-Eingang (CLK) gekoppelt ist.

7. Beleuchtungsvorrichtung nach Anspruch 6,
**dadurch gekennzeichnet,**
**dass** die Verbindung vom ersten Anschluss (E1) des Entstörnetzwerks (10) zum zweiten Anschluss (Z2) des Zeitglieds (12) durch einen ersten vorgebbaren Widerstand (R2, C1, R1) definiert ist, wobei die Verbindung vom ersten (E1) zum dritten Anschluss (E3) des Entstörnetzwerks (10) durch einen zweiten vorgebbaren Widerstand (R3, C2) definiert ist, wobei für ein DC-Signal der erste vorgebbare Widerstand (R2, C1, R1) um mindestens einen Faktor 10 kleiner ist als der zweite vorgebbare Widerstand (R3, C2), und wobei für das AC-Störsignal der erste vorgebbare Widerstand (R2, C1, R1) um mindestens einen Faktor 10 größer ist als der zweite vorgebbare Widerstand (R3, C2).

## Claims

1. Illumination device having a light source and a touch actuator which comprises a pushbutton switch (T), a terminal for a supply voltage (Uᵥ) and a D flip-flop (14), wherein the D flip-flop (14) has a Set input (S), a Reset input (R), a Clock input (CLK), a Data input (D), a Q output (Q) and a Qbar output, wherein the light source is connected to the Q output (Q) or to the Qbar output, wherein the pushbutton switch (T) has a first (A1) and a second terminal (A2), wherein the first terminal (A1) is connected to the terminal for the supply voltage (Uᵥ) and the second terminal (A2) is connectable to the supply voltage (Uv),
**characterised in that**
it additionally comprises:
an interference suppression network (10) which has a first (E1), a second (E2) and a third terminal (E3), wherein the first terminal (E1) of the interference suppression network (10) is coupled to the second terminal (A2) of the pushbutton switch (T), the second terminal (E2) of the interference suppression network (10) is coupled to the Clock input (CLK) and the third terminal (E3) of the interference suppression network (10) is coupled to a terminal for a reference potential (Uᵥ),
wherein the interference suppression network (10) has a connection between its first (E1) and its third terminal (E3) which constitutes a high-impedance resistance for a DC signal and a low-impedance resistance for an AC interference signal.

2. Illumination device according to claim 1,
**characterised in that**
the terminal for a reference potential constitutes the terminal for the supply voltage (Uᵥ).

3. Illumination device according to one of claims 1 or 2,
**characterised in that**
the interference suppression network (10) comprises at least one ohmic resistor (R3) and at least one capacitor (C2) which are connected in series with one another.

4. Illumination device according to claim 3,
**characterised in that**
the first terminal (E1) and the second terminal (E2) of the interference suppression network (10) are coupled to the terminal of the ohmic resistor (R3) which is turned away from the capacitor (C2), and **in that** the third terminal (E3) of the interference suppression network (10) is coupled to the terminal of the capacitor (C2) which is turned away from the ohmic resistor (R3).

5. Illumination device according to claim 3,
**characterised in that**
the first terminal (E1) of the interference suppression network (10) is coupled to the terminal of the ohmic resistor (R3) which is turned away from the capacitor (C2), **in that** the second terminal (E2) of the interference suppression network (10) is coupled to the connection point between the ohmic resistor (R3) and the capacitor (C2), and **in that** the third terminal (E3) of the interference suppression network (10) is coupled to the terminal of the capacitor (C2) which is turned away from the ohmic resistor (R3).

6. Illumination device according to one of the preceding claims,
**characterised in that**
it additionally comprises:
a timing element (12) having a time constant, wherein the timing element (12) also has a first (Z1), a second (Z2) and a third terminal (Z3), wherein the first terminal (Z1) is coupled to the second terminal (E2) of the interference suppression network (10), wherein the second terminal (Z2) of the timing element (12) is coupled to a reference potential, and wherein the third terminal (Z3) of the timing element (12) is coupled to the Clock input (CLK).

7. Illumination device according to claim 6,
**characterised in that**
the connection from the first terminal (E1) of the interference suppression network (10) to the second terminal (Z2) of the timing element (12) is defined by means of a first predeterminable resistance (R2, C1, R1), wherein the connection from the first (E1) to the third terminal (E3) of the interference suppression network (10) is defined by means of a second predeterminable resistance (R3, C2), wherein the first predeterminable resistance (R2, C1, R1) is less by at least a factor of 10 than the second predeterminable resistance (R3, C2) for a DC signal, and wherein the first predeterminable resistance (R2, C1, R1) is greater by at least a factor of 10 than the second predeterminable resistance (R3, C2) for the AC interference signal.

## Revendications

1. Dispositif d'éclairage ayant une source lumineuse et un dispositif à touche qui comprend une touche (T), une borne pour une tension d'alimentation (Uᵥ) et une bascule D (14), la bascule D (14) ayant une entrée de mise à un (S), une entrée de remise à zéro (R), une entrée d'horloge (CLK), une entrée de données (D), une sortie Q (Q) et une sortie Qbar, la source lumineuse étant raccordée à la sortie Q (Q) ou à la sortie Qbar, la touche (T) présentant une première borne (A1) et une deuxième borne (A2), la première borne (A1) étant reliée à la borne pour la tension d'alimentation (Uᵥ) et la deuxième borne (A2) pouvant être reliée à la tension d'alimentation (Uᵥ),
**caractérisé en ce qu'**il comprend en outre :
un circuit de déparasitage (10) qui comporte une première borne (E1), une deuxième borne (E2) et une troisième borne (E3), la première borne (E1) du circuit de déparasitage (10) étant couplée à la deuxième borne (A2) de la touche (T), la deuxième borne (E2) du circuit de déparasitage (10) étant couplée à l'entrée d'horloge (CLK) et la troisième borne (E3) du circuit de déparasitage (10) étant couplée à une borne pour un potentiel de référence (Uᵥ),
le circuit de déparasitage (10) présentant, entre sa première borne (E1) et sa troisième borne (E3), une liaison qui constitue une résistance de valeur ohmique élevée pour un signal CC et une résistance de valeur ohmique faible pour un signal parasite CA.

2. Dispositif d'éclairage selon la revendication 1, **caractérisé en ce que** la borne pour un potentiel de référence constitue la borne pour la tension d'alimentation (Uᵥ).

3. Dispositif d'éclairage selon l'une des revendications 1 ou 2, **caractérisé en ce que** le circuit de déparasitage (10) comprend au moins une résistance ohmique (R3) et au moins un condensateur (C2) qui sont montés en série entre eux.

4. Dispositif d'éclairage selon la revendication 3, **caractérisé en ce que** la première borne (E1) et la deuxième borne (E2) du circuit de déparasitage (10) sont couplées à la borne de la résistance ohmique (R3) qui est opposée au condensateur (C2) et **en ce que** la troisième borne (E3) du circuit de déparasitage (10) est couplée à la borne du condensateur (C2) qui est opposée à la résistance ohmique (R3).

5. Dispositif d'éclairage selon la revendication 3, **caractérisé en ce que** la première borne (E1) du circuit de déparasitage (10) est couplée à la borne de la résistance ohmique (R3) qui est opposée au condensateur (C2), **en ce que** la deuxième borne (E2) du circuit de déparasitage (10) est couplée au point de liaison entre la résistance ohmique (R3) et le condensateur (C2) et **en ce que** la troisième borne (E2) du circuit de déparasitage (10) est couplée à la borne du condensateur (C2) qui est opposée à la résistance ohmique (R3).

6. Dispositif d'éclairage selon l'une des revendications précédentes, **caractérisé en ce qu'**il comprend en outre :
un élément temporisateur (12) ayant une constante de temps, l'élément temporisateur (12) comportant également une première borne (Z1), une deuxième borne (Z2) et une troisième borne (Z3), la première borne (Z1) étant couplée à la deuxième borne (E2) du circuit de déparasitage (10), la deuxième borne (Z2) de l'élément temporisateur (12) étant couplée à un potentiel de référence et la troisième borne (Z3) de l'élément temporisateur (12) étant couplée à l'entrée d'horloge (CLK).

7. Dispositif d'éclairage selon la revendication 6, **caractérisé en ce que** la liaison de la première borne (E1) du circuit de déparasitage (10) vers la deuxième borne (Z2) de l'élément temporisateur (12) est définie par une première résistance prédéterminable (R2, C1, R1), la liaison de la première borne (E1) vers la troisième borne (E3) du circuit de déparasitage (10) étant définie par une deuxième résistance prédéterminable (R3, C2), la première résistance prédéterminable (R2, C1, R1) étant, pour un signal CC, d'au moins un facteur 10 inférieure à la deuxième résistance prédéterminable (R3, C2) et la première résistance prédéterminable (R2, C1, R1) étant, pour le signal parasite CA, d'au moins un facteur 10 supérieure à la deuxième résistance prédéterminable (R3, C2).
